# EUROPÄISCHE PATENTSCHRIFT

(11) **EP 2 981 420 B1**
(45) Veröffentlichungstag und Bekanntmachung des Hinweises auf die Patenterteilung: **19.12.2018**
(21) Anmeldenummer: 14718508.6
(22) Anmeldetag: 04.04.2014
(51) Int. Cl.: B42D 25/369, G07D 7/04

(54) **SICHERHEITSELEMENT FÜR WERTDOKUMENTE**
SECURITY ELEMENT FOR VALUABLE DOCUMENTS
ÉLÉMENT DE SÉCURITÉ POUR DOCUMENTS DE VALEUR

(30) Priorität: 04.04.2013 DE 102013005839
(43) Veröffentlichungstag der Anmeldung: 10.02.2016
(73) Patentinhaber: Giesecke+Devrient Currency Technology GmbH, 81677 München (DE)
(72) Erfinder: RAHM, Michael, 83646 Bad Tölz (DE); HEIM, Manfred, 83646 Bad Tölz (DE); RAUCH, Andreas, 83666 Waakirchen (DE); SCHÜTZMANN, Jürgen, 85276 Pfaffenhofen (DE); HOFFMÜLLER, Winfried, 83646 Bad Tölz (DE)
(86) Internationale Anmeldenummer: PCT/EP2014/000912
(87) Internationale Veröffentlichungsnummer: WO 2014/161674

(56) Entgegenhaltungen:
- EP-A1- 1 172 806
- EP-A2- 2 039 729
- DE-A1- 19 650 759
- DE-A1-102006 055 169
- DE-A1-102010 019 766
- US-A1- 2007 018 004

## Beschreibung

Die Erfindung betrifft ein Sicherheitselement zur Absicherung von Wertdokumenten.

Aus dem Stand der Technik ist es bekannt, Wertdokumente mit Sicherheitselementen, etwa Sicherheitsstreifen oder auch Sicherheitsfäden, auszustatten, die magnetisches Material enthalten. Das magnetische Material kann dabei durchgehend oder bereichsweise, zum Beispiel in Form einer magnetischen Kodierung auf das Sicherheitselement aufgebracht sein. Zur magnetischen Kodierung eines Sicherheitsfadens dient beispielsweise eine bestimmte Abfolge von magnetischen und nichtmagnetischen Bereichen, die charakteristisch für Art des zu sichernden Wertdokuments ist. Außerdem ist es bekannt, verschiedene magnetische Magnetmaterialien für eine Kodierung zu verwenden, beispielsweise Magnetmaterialien mit unterschiedlicher Koerzitivfeldstärke. Übliche Magnetkodierungen eines Sicherheitselements bestehen aus Kodierungselementen, die durch hoch- bzw. niederkoerzitive Magnetbereiche gebildet werden, welche in bestimmter Weise auf dem Sicherheitselement angeordnet sind. Die hoch- und niederkoerzitiven Magnetbereiche werden üblicherweise durch hartmagnetische Magnetmaterialien gebildet, die auch ohne Einwirkung eines Magnetfelds eine große remanente Magnetisierung aufweisen. Diese Kodierungselemente aus durchgehend flächig auf das Sicherheitselement aufgebrachten Magnetbereichen werden im Folgenden als konventionelle Kodierungselemente bezeichnet.

Die US2007/ 0018004 A1 offenbart ein Identifizierungselement mit verschiedenen gitterförmigen Kodierungselementen, wobei jedoch die Gitterstreifen verschiedener Kodierungselemente immer in verschiedene Richtung weisen müssen, um anhand der angegebenen Detektionstechnik voneinander unterschieden werden zu können. US 2007/018004 offenbart nicht, dass der Abstand zwischen jeweils zwei benachbarten Kodierungselementen mindestens 2 mm beträgt.

Die EP2039729 A2 offenbart magnetische flakes mit magnetisch anisotropen Gitterstreifen, die für ein Sicherheitselement eingesetzt werden können. Die magnetisch anisotropen Gitterstreifen der magnetischen flakes dienen dort aber nur dazu, die magnetischen flakes in einer Trägerflüssigkeit durch ein externes Magnetfeld in dieselbe Richtung auszurichten. Bei diesen magnetischen flakes handelt es sich jedoch nicht um magnetische Kodierungselemente einer magnetischen Kodierung eines Sicherheitselements.

Die DE102006055169 A1 offenbart zwar ein Sicherheitselement mit einer magnetischen Kodierung, aber keinen gitterförmigen Magnetbereich. Denn auch die Randspuren bilden keinen gitterförmigen Magnetbereich.

Auch die DE19650759 A1 offenbart ein Sicherheitselement mit einer magnetischen Kodierung aus mehreren parallelen Streifen, die jedoch eine makroskopische Größe haben, aber keine magnetische Formanisotropie.

Der Erfindung liegt die Aufgabe zugrunde, eine Möglichkeit zur magnetischen Kodierung eines Sicherheitselements anzugeben, die eine größere Fälschungssicherheit bietet.

Diese Aufgabe wird durch die Gegenstände der unabhängigen Ansprüche gelöst. Weiterbildungen sind Gegenstand der Unteransprüche.

Das erfindungsgemäße Sicherheitselement ist ein maschinenlesbares Sicherheitselement, das eine magnetische Kodierung aus zwei oder mehreren magnetischen Kodierungselementen aufweist. Die magnetischen Kodierungselemente weisen jeweils einen gitterförmigen Magnetbereich auf, der durch mehrere parallel zueinander verlaufende Gitterstreifen aus magnetischem Material gebildet ist. Diese Gitterstreifen des jeweiligen magnetischen Kodierungselements weisen jeweils eine magnetische Anisotropie auf, deren magnetische Vorzugsrichtung entlang der Gitterstreifen verläuft, insbesondere eine magnetische Formanisotropie. Die magnetische Anisotropie kann aber auch durch andere Anisotropieeffekte erreicht oder verstärkt werden.

Ein Vorteil des Kodierungselements, das einen gitterförmigen Magnetbereich aus Gitterstreifen mit magnetischer Anisotropie aufweist, besteht darin, dass durch die magnetisch anisotropen Gitterstreifen eine andere Magnetisierungsrichtung erreichbar ist als es bei einem konventionellen Magnetbereich möglich ist. Während bei konventionellen Kodierungselementen die Magnetisierung immer parallel zu dem angelegten Magnetfeld verläuft, führen die Gitterstreifen durch ihre magnetische Anisotropie dazu, dass sich die Magnetisierungsrichtung des Kodierungselements von der Richtung des angelegten Magnetfelds unterscheiden kann. Durch die magnetische Anisotropie der Gitterstreifen wird erreicht, dass ein Magnetfeld, das zum Magnetisieren der magnetischen Kodierungselemente in einem spitzen Winkel zu den Gitterstreifen des magnetischen Kodierungselements angelegt wird, zu einer Magnetisierung des jeweiligen magnetischen Kodierungselements führt, die sowohl eine Magnetisierungskomponente parallel zu dem angelegten Magnetfeld als auch eine Magnetisierungskomponente senkrecht zu dem angelegten Magnetfeld aufweist.

Die resultierenden Magnetsignale, die die gitterförmigen Magnetbereiche liefern, können durch konventionelle Magnetbereiche nicht nachgestellt werden. Die Kodierungselemente mit gitterförmigem Magnetbereich erhöhen daher die Fälschungssicherheit des Sicherheitselements, das eines oder mehrere dieser Kodierungselemente aufweist.

Desweiteren haben die gitterförmigen Magnetbereiche den Vorteil gegenüber konventionellen Magnetbereichen, dass sie besser in das Design eines Sicherheitselements oder in das Wertdokumentdesign integrierbar sind. Da konventionelle, durch Druck von Magnetfarbe hergestellte Magnetbereiche die schwarze Farbe der Magnetfarbe aufweisen, werden diese üblicherweise durch eine opake Schicht abgedeckt, damit sie per Auge nicht sichtbar sind. Die erfindungsgemäßen gitterförmigen Magnetbereiche erscheinen dagegen nicht schwarz, sondern können - je nach Herstellungsverfahren und in Abhängigkeit der gewählten Gittereigenschaften - metallisch glänzend erscheinen oder auch streifenförmig erscheinen. Sowohl die metallisch glänzende als auch die streifenförmige Erscheinung des erfindungsgemäßen Kodierungselements können als Teil des Wertdokumentdesigns verwendet werden.

Beispielsweise weist das erfindungsgemäße Sicherheitselement einen gitterförmigen Magnetbereich auf, dessen Umriss einem Motiv entspricht, das Teil des Designs des Sicherheitselements oder Teil des Wertdokumentdesigns ist. Der Umriss kann einem geometrischen Objekt entsprechen, z.B. einem Kreis oder einem Vieleck, oder auch einer im Design vorgesehenen Freiform. Das erfindungsgemäße Sicherheitselement kann auch weitere, zur visuellen Verifikation des Sicherheitselements geeignete Bereiche aufweisen oder mit zur visuellen Verifikation vorgesehenen Sicherheitselementen kombiniert werden.

Insbesondere weist die magnetische Kodierung zwei oder mehr als zwei magnetische Kodierungselemente auf, die entlang einer Kodierungsrichtung auf oder in dem Sicherheitselement angeordnet sind. Die Kodierungsrichtung ist diejenige Richtung, entlang der die Kodierungselemente auf dem Sicherheitselement angeordnet sind. Diese Kodierungsrichtung ist üblicherweise die Längsrichtung des Sicherheitselements. Als Längsrichtung des Sicherheitselements wird dabei die Richtung bezeichnet, in der das Sicherheitselement seine größte Ausdehnung besitzt. Es können dabei eine oder mehrere parallele Reihen mit zwei oder mehr als zwei Kodierungselementen vorgesehen sein.

Die Kodierungselemente weisen entlang der Kodierungsrichtung einen Mindestabstand voneinander auf, damit sie mit Hilfe eines ortsauflösenden Magnetsensors voneinander getrennt detektiert werden können. Dadurch wird erreicht, dass die Anordnung der Kodierungselemente auf dem Sicherheitselement mit großer Zuverlässigkeit detektiert werden kann. Insbesondere beträgt der Abstand zwischen den jeweils benachbarten Kodierungselementen des Sicherheitselements (für alle Kodierungselemente) mindestens 50% der Länge des kürzesten Kodierungselements, das das Sicherheitselement entlang der Kodierungsrichtung aufweist, vorzugsweise mindestens 100% der Länge des kürzesten Kodierungselements. Erfindungsgemäß beträgt der Abstand zwischen den jeweils benachbarten Kodierungselementen mindestens 2 mm.

Das Sicherheitselement weist in seiner magnetischen Kodierung bevorzugt zwei oder mehrere Kodierungselemente auf, die dieselbe Koerzitivfeldstärke haben. Die Länge dieser Kodierungselemente entlang der Kodierungsrichtung kann gleich oder unterschiedlich sein. Diese Kodierungselemente können unmittelbar zueinander benachbart sein oder durch andere Kodierungselemente und/ oder nichtmagnetische Bereiche voneinander getrennt sein. Durch dieselbe Koerzitivfeldstärke wird erreicht, dass sich diese Kodierungselemente bei einer Ummagnetisierung durch ein externes Magnetfeld möglichst gleich verhalten. Dadurch wird die Detektion der Kodierungselemente vereinfacht. Die Kodierungselemente können aber natürlich mit Hilfe einer ortsaufgelösten Detektion voneinander unterschieden werden. Beispielsweise weist das Sicherheitselement in seiner magnetischen Kodierung mindestens zwei gleiche Kodierungselemente auf, die sich in ihren magnetischen Eigenschaften nicht voneinander unterscheiden.

Die Gitterstreifen des Kodierungselements verlaufen insbesondere in einem spitzen Winkel zu der Kodierungsrichtung, insbesondere zur Längsrichtung, des Sicherheitselements. Bevorzugt beträgt dieser spitze Winkel zwischen 20° und 70°, besonders bevorzugt zwischen 30° und 60°. Da zur Magnetisierung des Sicherheitselements üblicherweise ein Magnetfeld senkrecht oder parallel zur Kodierungsrichtung des Sicherheitselements angelegt wird, wird so in beiden Fällen, d.h. sowohl bei einem Magnetfeld senkrecht als auch bei einem Magnetfeld parallel zur Kodierungsrichtung, ein spitzer Winkel zwischen den Gitterstreifen und der Magnetisierungsrichtung erreicht. Die Magnetkodierung des Sicherheitselements kann damit durch verschiedene Magnetdetektoren, die unterschiedliche Magnetisierungsrichtungen verwenden, gelesen und von konventionellen Magnetkodierungen unterschieden werden.

Das Sicherheitselement weist entlang der Kodierungsrichtung zwei oder mehrere erste magnetische Kodierungselemente auf. Beispielsweise weist das Sicherheitselement auch mindestens ein zweites magnetisches Kodierungselement auf. Die ersten und das zweite magnetische Kodierungselement weisen jeweils einen gitterförmigen Magnetbereich auf, der durch mehrere parallel zueinander verlaufende Gitterstreifen aus magnetischem Material gebildet wird. Die Gitterstreifen der ersten Kodierungselemente und die Gitterstreifen des zweiten Kodierungselements sind jeweils derart ausgebildet, dass sie eine magnetische Anisotropie aufweisen. Die Gitterstreifen des magnetischen Kodierungselements, insbesondere die Gitterstreifen des ersten/ zweiten Kodierungselements, verlaufen jeweils im Wesentlichen parallel zueinander. Die Gitterstreifen jedes ersten Kodierungselements verlaufen im Wesentlichen parallel zu den Gitterstreifen des/ der anderen ersten Kodierungselemente. Die Gitterstreifen jedes zweiten Kodierungselements verlaufen im Wesentlichen parallel zu den Gitterstreifen des/ der anderen zweiten Kodierungselementen.

Beispielsweise sind die Gitterstreifen des jeweiligen Kodierungselements jeweils durchgehend gerade ausgebildet. Um das jeweilige Kodierungselement als Teil des Sicherheitselement- oder des Wertdokumentdesigns zu verwenden, können aber auch andere Varianten von Gitterstreifen zum Einsatz kommen: Zum Beispiel können die Gitterstreifen leicht wellig ausgebildet sein. Die einzelnen Gitterstreifen können auch eine oder mehrere Unterbrechungen aufweisen, in denen das magnetische Material fehlt. Innerhalb eines Kodierungselements können die Gitterstreifen auch mehrere kurze Striche aus magnetischem Material gebildet werden, die jeweils leicht versetzt zueinander liegen, aber im Wesentlichen parallel zueinander verlaufen. Auch die Gitterperiode der Gitterstreifen innerhalb eines Kodierungselements (oder auch die Gitterperiode der verschiedenen Kodierungselemente) kann variieren. Es kommt lediglich darauf an, dass die Gitterstreifen innerhalb des jeweiligen Magnetbereichs des Kodierungselements im Wesentlichen in dieselbe Richtung weisen. Dies umfasst auch, dass eine geringe Verkippung der einzelnen Gitterstreifen zueinander bestehen kann. Die Winkel der Verkippung der Gitterstreifen beträgt jedoch bevorzugt höchstens 10°.

Die magnetische Kodierung des Sicherheitselements kann auch zwei oder mehrere erste Kodierungselemente aufweisen, die entlang der Kodierungsrichtung auf oder in dem Sicherheitselement angeordnet sind, ohne dass auch ein zweites Kodierungselement mit gitterförmigen Magnetbereich in der Kodierung vorhanden ist.

Insbesondere kann die magnetische Kodierung des Sicherheitselements zwei oder mehr als zwei verschiedene Kodierungselemente aufweisen, die unterschiedlich ausgebildete gitterförmige Magnetbereiche aufweisen z.B. mit unterschiedlicher Orientierung der Gitterstreifen. Die magnetische Kodierung des Sicherheitselements weist in einem bevorzugten Ausführungsbeispiel mindestens zwei erste magnetische Kodierungselemente und mindestens ein zweites magnetisches Kodierungselement auf, wobei die Gitterstreifen des zweiten magnetischen Kodierungselements in eine andere Richtung verlaufen als die Gitterstreifen der ersten magnetischen Kodierungselemente. Zum Beispiel sind die ersten und der zweite gitterförmige Magnetbereich gleich aufgebaut und nur die Orientierung der Gitterstreifen ist unterschiedlich. Alternativ können für die ersten und das zweite Kodierungselement auch unterschiedliche Gitter verwendet werden, z.B. unterschiedliche Perioden, unterschiedliche Dicken und/ oder Breiten der Gitterstreifen, unterschiedliches magnetisches Material für die Gitterstreifen, etc.

Wenn für die ersten und das zweite Kodierungselement dasselbe Magnetmaterial verwendet wird und nur die Gitterparameter (z.B. Richtung, Periode, Breite) der jeweiligen Gitterstreifen unterschiedlich ist, benötigen unterschiedliche Kodierungselemente keine getrennten Prozessschritte, sondern können gleichzeitig durch dieselben Prozessschritte hergestellt werden.

Die Gitterstreifen des jeweiligen Kodierungselements, insbesondere des ersten und zweiten Kodierungselements, verlaufen in einem Ausführungsbeispiel jeweils in einem spitzen Winkel zu der Kodierungsrichtung (z.B. Längsrichtung) des Sicherheitselements, insbesondere in einem Winkel zwischen 20° und 70°, bevorzugt zwischen 30° und 60°, z.B. etwa 45°. Diese Winkel sind besonders gut geeignet für eine maschinelle Prüfung des Sicherheitselements, bei der das Sicherheitselement durch ein Magnetfeld magnetisiert wird, das senkrecht oder parallel zur Kodierungsrichtung des Sicherheitselements verläuft. Denn in diesem Fall unterscheidet sich die resultierende Magnetisierung des Kodierungselements mit dem gitterförmigen Magnetbereich stark von der resultierenden Magnetisierung eines konventionellen Kodierungselements.

Bevorzugt verlaufen die Gitterstreifen des zweiten magnetischen Kodierungselements in einem Winkel zwischen 60° und 120° zu den Gitterstreifen der ersten magnetischen Kodierungselemente, vorzugsweise in einem Winkel zwischen 70° und 110°, beispielsweise in einem Winkel von etwa 90°. Diese Winkel zwischen den Gitterstreifen haben den Vorteil, dass dasselbe Magnetisierungs-Magnetfeld, eine deutlich unterschiedliche Magnetisierung der ersten und des zweiten Kodierungselements hervorruft.

Die Breite und optional auch die Dicke, die das magnetische Material der Gitterstreifen, z.B. des ersten magnetischen Kodierungselements und des zweiten magnetischen Kodierungselements, aufweist, ist so gering gewählt, dass die Gitterstreifen, insbesondere die ersten und zweiten Gitterstreifen jeweils eine magnetische Formanisotropie aufweisen. Diese Formanisotropie führt dazu, dass die Gitterstreifen entlang der Längsrichtung der Gitterstreifen eine magnetische Vorzugsrichtung haben. Bei einer makroskopischen Breite und Dicke der Gitterstreifen haben die Magnetmaterialien dagegen keine Formanisotropie. Wenn die Breite und auch die Dicke aber mikroskopisch gering sind, z.B. in der Größenordnung der Austauschlänge lₑₓ=√(A/K_{D}) des magnetischen Materials der jeweiligen Gitterstreifen liegen (wobei A das Austauschintegral A und K_{D} der Streufeldenergie-Koeffizient sind), ergibt sich eine Formanisotropie mit einer magnetische Vorzugsrichtung entlang der Längsrichtung der Gitterstreifen. Um eine ausreichend große magnetische Formanisotropie zu erreichen, beträgt die Breite der Gitterstreifen jeweils höchstens 5 µm. Die Breite der Gitterstreifen liegt zwischen 100 nm und 5 µm, insbesondere zwischen 100 nm und 1 µm. Die Dicke der Gitterstreifen ist z.B. geringer als 1 µm. Das Verhältnis zwischen der Länge des jeweiligen Gitterstreifens und der Breite (bzw. der Dicke) des jeweiligen Gitterstreifens beträgt bevorzugt mindestens 3:1, insbesondere mindestens 5:1, bevorzugt mindestens 10:1.

Die magnetische Anisotropie der Gitterstreifen führt - ohne angelegtes Magnetfeld - zu einer remanenten Magnetisierung des jeweiligen Kodierungselements entlang einer Richtung, die parallel zu den Gitterstreifen des jeweiligen Kodierungselements verläuft, wobei senkrecht zu den Gitterstreifen eine vernachlässigbar geringe remanente Magnetisierung der Gitterstreifen erreicht wird. Durch die magnetische Anisotropie der Gitterstreifen wird erreicht, dass ein Magnetfeld, das, zum Magnetisieren des jeweiligen Kodierungselements, in einem spitzen Winkel zu den Gitterstreifen des jeweiligen Kodierungselements angelegt wird, zu einer remanenten Magnetisierung des jeweiligen Kodierungselements gemäß einem Magnetisierungsvektor führt, der sowohl eine Magnetisierungskomponente parallel zu dem angelegten Magnetfeld als auch eine Magnetisierungskomponente senkrecht zu dem angelegten Magnetfeld aufweist (die beide verschieden von Null sind). Zum Beispiel beträgt die Magnetisierungskomponente senkrecht zu dem angelegten Magnetfeld mindestens 20% der Magnetisierungskomponente parallel zu dem angelegten Magnetfeld.

Im Gegensatz dazu werden konventionelle Magnetbereiche, aufgrund ihrer isotropen magnetischen Eigenschaften, immer nur in die Richtung parallel zu dem angelegten Magnetfeld magnetisiert. Deren remanente Magnetisierung weist daher keine Komponente auf, die senkrecht zu dem angelegten Magnetfeld verläuft.

Die magnetische Anisotropie, insbesondere Formanisotropie, der Gitterstreifen des jeweiligen magnetischen Kodierungselements, insbesondere des jeweiligen ersten und/ oder zweiten Kodierungselements, ist bevorzugt derart ausgebildet, dass das jeweilige magnetische Kodierungselement, insbesondere das jeweilige erste und/ oder zweite magnetische Kodierungselement,
- in der Magnetisierungsrichtung parallel zu den Gitterstreifen eine Magnetisierungscharakteristik mit geöffneter Hystereseform aufweist, und
- in der Magnetisierungsrichtung senkrecht zu den Gitterstreifen eine Magnetisierungscharakteristik aufweist, die - im Vergleich zu der Magnetisierungscharakteristik parallel zu den Gitterstreifen - eine vernachlässigbar geringe remanente Magnetisierung aufweist. Die remanente Magnetisierung dieser Magnetisierungscharakteristik ist vorzugsweise mindestens einen Faktor 5 geringer als die remanente Magnetisierung, der Magnetisierungscharakteristik mit geöffneter Hystereseform, die das Kodierungselement in der Richtung parallel zu den Gitterstreifen hat. Beispielsweise verläuft die Magnetisierungscharakteristik, die das magnetische Kodierungselement senkrecht zu den Gitterstreifen aufweist, im Wesentlichen linear und weist einen nahezu geschlossenen Verlauf auf, es sind aber auch andere Kurvenverläufe möglich.

Die magnetische Anisotropie, insbesondere Formanisotropie, der Gitterstreifen ist insbesondere so ausgeprägt, dass
- die Magnetisierungscharakteristik mit geöffneter Hystereseform, die das magnetische Kodierungselement in der Magnetisierungsrichtung parallel zu den Gitterstreifen aufweist, eine Koerzitivfeldstärke von mindestens 10 Oe (0,796 kA/m) aufweist, vorzugsweise von mindestens 50 Oe (3,98 kA/m), und
- die Magnetisierungscharakteristik, die das magnetische Kodierungselement in der Magnetisierungsrichtung senkrecht zu den Gitterstreifen aufweist, eine im Vergleich dazu vernachlässigbar geringe Koerzitivfeldstärke aufweist.

In einer speziellen Variante verursachen die Gitterstreifen im sichtbaren Spektralbereich keine visuell wahrnehmbare Lichtbeugung. Zu diesem Zweck wird z.B. die Periode der Gitterstreifen des jeweiligen Magnetbereichs entsprechend gering gewählt, zum Beispiel beträgt die Periode der Gitterstreifen dazu weniger als 400 nm. Zur Unterdrückung einer visuell wahrnehmbaren Lichtbeugung können innerhalb des jeweiligen Kodierungselements auch die einzelnen Gitterstreifen geringfügig gegeneinander verkippt werden und/ oder die Gitterperiode variiert werden.

Die gitterförmigen Magnetbereiche des Kodierungselements können auch derart in das Sicherheitselement bzw. in das Wertdokument integriert werden, dass sie, bei Betrachtung des Wertdokuments per Auge, nicht sichtbar sind. Zum Beispiel befinden sich die gitterförmigen Magnetbereiche nicht an der Oberfläche, sondern im Inneren des Sicherheitselements bzw. des Wertdokuments. Die gitterförmigen Magnetbereiche sind z.B. ein- oder beidseitig durch eine oder mehrere weitere opake Materiallagen des Sicherheitselements oder des Wertdokuments abgedeckt.

Das Sicherheitselement lässt sich mit Hilfe eines Magnetsensors prüfen, der Magnetsignale des Sicherheitselements detektiert. Die magnetische Kodierung des Sicherheitselements lässt sich mit Hilfe eines ortsauflösenden Magnetsensors prüfen. Zum Magnetisieren der magnetischen Kodierungselemente wirkt vor dem Detektieren (und ggf. auch während des Detektierens) der Magnetsignale ein Magnetfeld auf das Sicherheitselement ein, dessen Richtung in einem spitzen Winkel zu den Gitterstreifen des magnetischen Kodierungselements verläuft. Der spitze Winkel beträgt bevorzugt zwischen 30° und 60°. Das Magnetsignal des Sicherheitselements ist dann charakteristisch für die anisotrope Magnetisierbarkeit der magnetischen Kodierungselemente. Im Magnetsignal zeigt sich so ein deutlicher Unterschied zu den konventionellen Kodierungselementen.

Bevorzugt wird der Wertdokumentbereich, in dem sich das Sicherheitselement befindet, beim Detektieren der Magnetsignale zweidimensional abgescannt. Dabei wird das Magnetsignal, zumindest in dem Bereich des Sicherheitselements, entlang zweier verschiedener Richtungen als Funktion der Position auf dem Wertdokument detektiert. Bevorzugt wird das Magnetsignal des Sicherheitselements als Funktion der Kodierungsrichtung der Magnetkodierung (z.B. als Funktion der Längsrichtung des Sicherheitselements) ausgewertet. Ausgewertet wird das Magnetsignal in solchen Bereichen des Sicherheitselements, in denen die Unterschiede der verschiedenen Kodierungselemente, insbesondere die Unterschiede gegenüber dem konventionellen Kodierungselementen, deutlich hervortreten. Dies hängt von der Richtung des angelegten Magnetfelds, von der Richtung der Gitterstreifen und von der Empfindlichkeitsrichtung der magnetosensitiven Elemente ab. Zum Beispiel werden die Magnetsignale der Ränder der Kodierungselemente ausgewertet.

Zur Herstellung der gitterförmigen Magnetbereiche gibt es verschiedene Möglichkeiten. Bevorzugt ist, das magnetische Material - an Stelle durch ein Druckverfahren - mit Hilfe eines Beschichtungsverfahrens auf ein Sicherheitselement-Substrat aufzubringen, bei dem eine Beschichtung aus magnetischem Material auf dem Sicherheitselement-Substrat abgeschieden wird. Bei dem Beschichtungsverfahren wird z.B. eine magnetische Metallschicht auf ein Sicherheitselement-Substrat aufgebracht. Die aufgebrachte magnetische Beschichtung, insbesondere magnetische Metallschicht, wird zu einem gitterförmigen Magnetbereich strukturiert, z.B. durch selektive Demetallisierung der Zwischenräume zwischen den Gitterstreifen oder durch Einbringen von Unebenheiten mit Hilfe eines Oberflächenreliefs, das vor oder nach der Magnetschicht in das Substrat eingebracht wird.

Ein Vorteil des Beschichtungsverfahrens im Vergleich zum bisher üblichen Drucken der Magnetschicht ist, dass die Schichtdicke und daher auch die remanente Magnetisierung der Magnetschicht deutlich besser kontrollierbar ist. Denn die aufzubringende Schichtdicke kann bei diesen Beschichtungsverfahren einfach gesteuert werden. Im Gegensatz dazu ist bei gedruckten Magnetbereichen die remanente Magnetisierung nur ungenau einstellbar, da Menge/ Konzentration des magnetischen Materials - herstellungsbedingt - großen Schwankungen unterworfen ist. Vorteilhaft ist außerdem, dass die Schichtdicke der erfindungsgemäßen gitterförmigen Magnetbereiche wesentlich geringer als die Schichtdicke, die - bei vergleichbarer Signalstärke des Magnetsignals - für konventionelle, durch ein Druckverfahren aufgebrachte Magnetbereiche notwendig ist. Daher können z.B. auch Folienelemente mit einer erfindungsgemäßen Magnetkodierung ausgestattet werden, ohne eine zu große Dicke des Folienelements in Kauf nehmen zu müssen.

Die bisher zur Herstellung von magnetischen Kodierungselementen verwendeten magnetischen Druckpigmente haben außerdem eine unveränderliche Koerzitivfeldstärke, da diese ein nicht beeinflussbarer Materialparameter des jeweiligen Druckpigments ist. Die erfindungsgemäßen Kodierungselemente haben demgegenüber den Vorteil, dass die Koerzitivfeldstärke beim Herstellungsverfahren einstellbar ist, durch Wahl der Gitterparameter, z.B. Gitterperiode oder Breite der Gitterstreifen. So können aus demselben Magnetmaterial - in Abhängigkeit der gewählten Gitterparameter - Magnetbereiche mit verschiedenen Koerzitivfeldstärken hergestellt werden.

Die magnetische Beschichtung, aus der die Gitterstreifen gebildet werden, werden bevorzugt mit Hilfe eines Beschichtungsverfahrens der Dünnschichttechnologie hergestellt, z.B. mittels thermischen Verdampfen oder Elektronenstrahlverdampfen oder Sputtern in einer Vakuumaperatur, oder durch CVD (Chemical Vapour Deposition) oder PECVD (Plasma Enhanced Chemical Vapour Deposition) oder durch elektrochemische Abscheidung aus einer Flüssigkeit.

Die magnetische Beschichtung, die bei dem Beschichtungsverfahren aufgebracht wird, enthält z.B. Eisen, Kobalt, Nickel oder Legierungen dieser Metalle. Diese Legierungen können auch Gd, B, Nd, Mo, Sm, Nb, o.a. enthalten. Ein geeignetes magnetisches Material ist z.B. Permalloy (ca. 80% Ni, 20% Fe). Bei dem Beschichtungsverfahren können auch Schichtsysteme aus verschiedenen magnetischen und nichtmagnetischen Schichten aufgebracht werden.

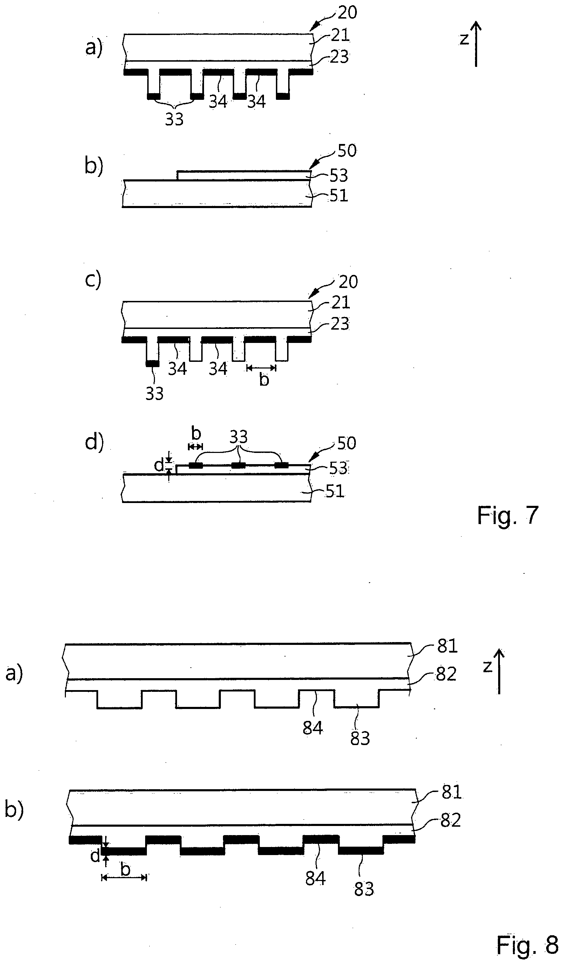

Die gitterförmigen Magnetbereiche können z.B. durch eines der folgenden Verfahren hergestellt werden:
a) Bei einem bevorzugten Herstellungsverfahren wird auf ein bestehendes gitterförmiges Oberflächenrelief, das in einer Schicht eines Sicherheitselements vorhanden ist, eine magnetische Beschichtung aufgebracht. Sowohl auf den erhabenen Stellen des gitterförmigen Oberflächenreliefs als auch in den Vertiefungen des gitterförmigen Oberflächenreliefs bilden sich streifenförmige magnetische Bereiche aus. Das gitterförmige Oberflächenrelief kann mittels Prägen, z.B. Prägen in UV-härtbaren Lack, oder auch mit Hilfe anderer Methoden hergestellt worden sein.
   Beispielsweise werden dazu Gitterstreifen in eine auf einem Substrat 81 vorhandene Schicht 82 eingeprägt, vgl. Fig. 8a. Durch die magnetische Beschichtung des geprägten Substrats bilden sich magnetische Bereiche 83 auf den erhabenen Stellen und magnetische Bereiche 84 in den Vertiefungen der geprägten Schicht 82. Sowohl die magnetischen Bereich 83 als auch die magnetischen Bereiche 84 bilden einen gitterförmigen Magnetbereich, deren Gitterstreifen jeweils eine magnetische Anisotropie aufweisen. In Fig. 8b ist für einen der Gitterstreifen beispielhaft dessen Breite b und Dicke d eingezeichnet. Dabei tragen sowohl die Gitterstreifen 83 als auch die Gitterstreifen 84 zur anisotropen Magnetisierung des jeweiligen Kodierungselements bei. Da bei dem so hergestellten Kodierungselement insgesamt mehr Gitterstreifen vorhanden sind als bei einem Gitter mit nichtmagnetischen Zwischenräumen, ergibt sich bei der Detektion vorteilhaft ein größeres Magnetsignal.
   Je nach Art des Beschichtungstechnik kann es sein, dass auch die Flanken der Vertiefungen des Oberflächenreliefs mit magnetischem Material beschichtet werden. Dadurch kann es zu einer Verbindung zwischen den magnetischen Bereichen 83 und 84 durch magnetisches Material kommen. Es hat sich jedoch gezeigt, dass auch in diesem Fall eine ausreichende magnetische Anisotropie der Gitterstreifen erreicht werden kann, um die erfindungsgemäße Wirkung zu erzielen, insbesondere solange die Schichtdicke des Magnetmaterials auf den Flanken sehr gering ist.
   Um eine deutliche Trennung der einzelnen Gitterstreifen zu erreichen, kann ein gitterförmiges Oberflächenrelief aus Reliefstrukturen mit wellenförmigem oder dreiecksförmigen Querschnitt, z.B. mit Sägezahnform, verwendet werden (z.B. durch Prägen herstellbar) und dieses unter schrägem Winkel beschichtet werden. Dadurch werden lediglich diejenigen Flanken der dreieckförmigen Reliefstrukturen mit magnetischem Material beschichtet, die der Richtung, aus der das magnetische Material kommt, zugewandt sind, während die dieser Richtung abgewandten Flanken der dreieckförmigen Reliefstrukturen frei von magnetischem Material bleiben.
b) Bei einem anderen bevorzugten Herstellungsverfahren werden die gitterförmigen Magnetbereiche durch ein Metalltransferverfahren hergestellt, durch das die magnetische Beschichtung gitterförmig strukturiert wird.
   Dazu wird in einer Schicht 23 eines ersten Substrats (Donorsubstrat 20 mit Folie 21) zunächst ein gitterförmiges Oberflächenrelief, z.B. eine gitterförmige Prägestruktur, hergestellt, das anschließend mit magnetischem Material (nicht haftfest) beschichtet wird, vgl. Fig. 7a. Sowohl auf den erhabenen Stellen als auch auf den Vertiefungen des gitterförmigen Oberflächenreliefs bilden sich dabei magnetische Bereiche 33 bzw. 34. Ein zweites Substrat (Akzeptorsubstrat 50 mit Folie 51) wird an den gewünschten Stellen mit einer Kleberschicht 53 versehen, vgl. Fig. 7b. Das zweite Substrat 50 wird mit dem ersten Substrat 20 in Verbindung gebracht (ggf. unter Einwirkung von Druck und erhöhter Temperatur), wobei die Kleberschicht 53 des zweiten Substrats mit den magnetischen Bereichen 33 der erhabenen Stellen in Kontakt kommt. Anschließend werden die beiden Substrate 20, 50 wieder voneinander getrennt, wobei das magnetische Material 33 der erhabenen Stellen an der Kleberschicht 53 haften bleibt und sich von dem ersten Substrat 20 bzw. von der Schicht 23 ablöst. Auf der Gitterstruktur des ersten Substrats verbleiben die in den Vertiefungen vorhandenen magnetischen Bereiche 34, die einen gitterförmigen Magnetbereich bilden, vgl. Fig. 7c. Bei dem zweiten Substrat 50 bilden die transferierten magnetischen Bereiche 33 der erhabenen Stellen einen weiteren gitterförmigen Magnetbereich, dessen Gitterstreifen komplementär zu denen des ersten Substrats 20 ausgebildet sind, vgl. Fig. 7d. In Fig. 7d ist für einen der Gitterstreifen beispielhaft dessen Breite b und Dicke d eingezeichnet. Die gitterförmigen Magnetbereiche beider Substrate können zur Herstellung erfindungsgemäßer Sicherheitselemente verwendet werden.
c) Eine weitere Möglichkeit zur Herstellung der gitterförmigen Magnetbereiche besteht darin, auf ein (ebenes) Sicherheitselement-Substrat zunächst eine (flächige) magnetische Beschichtung aufzubringen und diese magnetische Beschichtung in den Zwischenbereichen der Gitterstreifen wieder zu entfernen. Das Entfernen der magnetischen Beschichtung in den Zwischenbereichen der Gitterstreifen kann durch Ätzen oder mittels eines Waschfarbeverfahrens oder mit Hilfe eines Photolack-Liftoff-Verfahrens oder einer Kombination dieser Verfahren durchgeführt werden. Eine weitere Möglichkeit zum Entfernen der magnetischen Beschichtung ist durch Bestrahlung mit einem Laser. In einer speziellen Variante wird die magnetische Beschichtung in den Zwischenbereichen durch Laser-Bestrahlung entfernt, wobei das Laserlicht durch Stablinsen hindurch auf die magnetische Beschichtung gerichtet wird, die das Laserlicht in Form von Gitterstreifen bündeln und die magnetische Beschichtung dort entfernen.
   Zum Entfernen der Zwischenbereiche der Gitterstreifen mittels Ätzen wird eine Resistschicht auf die (ebene) magnetische Beschichtung aufgebracht. Diese Resistschicht wird gitterförmig strukturiert und dient als Ätzmaske für das Ätzen der magnetischen Beschichtung. Beispielsweise wird als Resist eine Photolackschicht aufgebracht, die nach lokaler Belichtung mit einem gitterförmigen Muster, durch ein Entwicklerbad teilweise wieder entfernt wird. Die nach dem Entwickeln verbleibenden gitterförmigen Photolackbereiche wirken als Ätzmaske für den anschließenden Ätzschritt, bei dem die magnetische Beschichtung in den Bereichen, die nicht mit Photolack geschützt sind, entfernt wird.
   Beim Waschfarbeverfahren wird Waschfarbe gitterförmig auf ein Substrat gedruckt, darauf flächig eine magnetische Beschichtung aufgebracht und anschließend die magnetische Beschichtung in den gitterförmigen Waschfarbebereichen durch Waschen wieder entfernt. Da nach dem Waschen nur die magnetische Beschichtung in den Bereichen verbleibt, die nicht mit Waschfarbe bedruckt waren, entstehen so die Gitterstreifen eines oder mehrerer gitterförmiger Magnetbereiche.
   Das Photolack-Liftoff-Verfahren funktioniert analog zu dem Waschfarbeverfahren, wobei Photolack an Stelle der Waschfarbe auf das Substrat aufgebracht wird. Durch lokale Belichtung werden gitterförmige Bereiche definiert, in denen der Photolack beim anschließenden Entwickeln wieder abgelöst wird. Nach dem Entwickeln wird die magnetische Beschichtung flächig aufgebracht, sowohl auf den gitterförmig vorhandenen Photolack als auch auf die dazwischen liegenden Substratbereiche. Mit einem Lösungsmittel wird der Photolack in den unbelichteten Bereichen wieder entfernt, wobei sich die auf dem Photolack aufgebrachte magnetische Beschichtung mit dem Photolack ablöst. In den Bereichen, die zwischen den Photolack-Gitterstreifen liegen, entstehen dabei die Gitterstreifen für die gitterförmigen Magnetbereiche.
d) Eine weitere Möglichkeit zur Herstellung der gitterförmigen Magnetbereiche besteht darin, auf ein Substrat eines Sicherheitselements flächig eine magnetische Beschichtung aufzubringen und diese zu prägen. Die Gitterstreifen der gitterförmigen Magnetbereiche werden durch Prägen der magnetischen Beschichtung hergestellt. Ggf. werden auch weitere Schichten mitgeprägt, die über oder unter der magnetischen Beschichtung liegen. Die magnetische Beschichtung kann z.B. im Bereich eines holographisch zu strukturierenden Bereichs des Sicherheitselements aufgebracht werden, bevor das holographische Muster des Sicherheitselements geprägt wird. Die Gitterstreifen der gitterförmigen Magnetbereiche können dann mit der Hologrammprägung des holographischen Musters mitgeprägt werden.

Die nach den Verfahren a)-d) hergestellten gitterförmigen Magnetbereiche können durch weitere Schichten bedeckt werden. Der so erhaltene Schichtaufbau kann durch Transferkaschierung auf andere Folienelemente oder Substrate übertragen werden, die weitere Sicherheitselemente enthalten. Eine registergenaue Transferkaschierung ist dann bevorzugt, wenn die gitterförmigen Magnetbereiche gezielt in bestimmten Bereichen des weiteren Sicherheitselements anzuordnen sind. Zum Beispiel können die gitterförmigen Magnetbereiche auf diese Weise gezielt außerhalb von visuell sichtbaren Aussparungen (Cleartext) angeordnet werden oder gezielt hinter Hologrammstrukturen des Sicherheitselements.

An Stelle eines Rechteckgitters, wie in den Fig. 7 und 8 gezeigt, können auch andere Gitterformen verwendet werden. Beispielsweise kann - an Stelle der Rechtecksform - auch ein dreiecksförmiger oder wellenförmiger Querschnitt der Gitterstreifen oder auch andere Querschnittsformen gewählt werden.

Bei denjenigen Herstellungsverfahren, bei den vor oder nach dem Aufbringen der Magnetschicht auf das Substrat, ein Oberflächenrelief in das Substrat (bzw. in Substrat und Magnetschicht) eingebracht wird, erhält man eine durchgehende Magnetschicht, deren Gitterstreifen auf unterschiedlichen Ebenen bzw. Flanken des Oberflächenreliefs liegen. Die Gitterstreifen sind dann keine diskrete Elemente, sondern hängen zumindest teilweise zusammen (z.B. stufig versetzte Gitterstreifen, die nur eine dünne Materialverbindung haben). Da sie aber nur geringfügig zusammenhängen, weisen die Gitterstreifen trotzdem eine magnetische Anisotropie auf. Vorteilhaft ist so eine durchgehende Magnetschicht in Bezug auf die Detektion des Magnetsignals, da - im Vergleich zu diskreten Gitterstreifen - quasi die doppelte Anzahl an Gitterstreifen vorliegt, die ein entsprechend höheres Magnetsignal liefern.

Nachfolgend wird die Erfindung beispielhaft anhand der folgenden Figuren erläutert. Es zeigen:
- Fig. 1a-b: Magnetisierung eines gitterförmigen Magnetbereichs durch ein Magnetfeld, das senkrecht zu den Gitterstreifen (Fig. 1a) bzw. parallel zu den Gitterstreifen verläuft (Fig. 1b),
- Fig. 1c: Magnetisierungscharakteristik des gitterförmigen Magnetbereichs in den Fällen der Fig. 1a und 1b,
- Fig. 2a-c: erstes Beispiel eines Sicherheitselements (Fig. 2a), dessen Magnetisierung durch ein Magnetfeld Hₓ (Fig. 2b) und vektorielle Zerlegung der Magnetisierung (Fig. 2c),
- Fig. 3a: zweidimensionale Darstellung der in z-Richtung detektierten Magnetsignale des Sicherheitselements aus Fig. 2a-b,
- Fig. 3b: Verlauf der in z-Richtung detektierten Magnetsignale entlang der y-Richtung an der Position x=x0,
- Fig. 4: Anordnung zur Prüfung der Magnetsignale des Sicherheitselements,
- Fig. 5a-b: zwei Ausführungsbeispiele des erfindungsgemäßen Sicherheitselements,
- Fig. 6: Beispiel eines Sicherheitselements,
- Fig. 7a-d: Querschnittsdarstellungen zu einem ersten bevorzugten Herstellungsverfahren, wobei die Gitterstreifen senkrecht zur Zeichenebene verlaufen,
- Fig. 8a-b: Querschnittsdarstellungen zu einem zweiten bevorzugten Herstellungsverfahren, wobei die Gitterstreifen senkrecht zur Zeichenebene verlaufen.

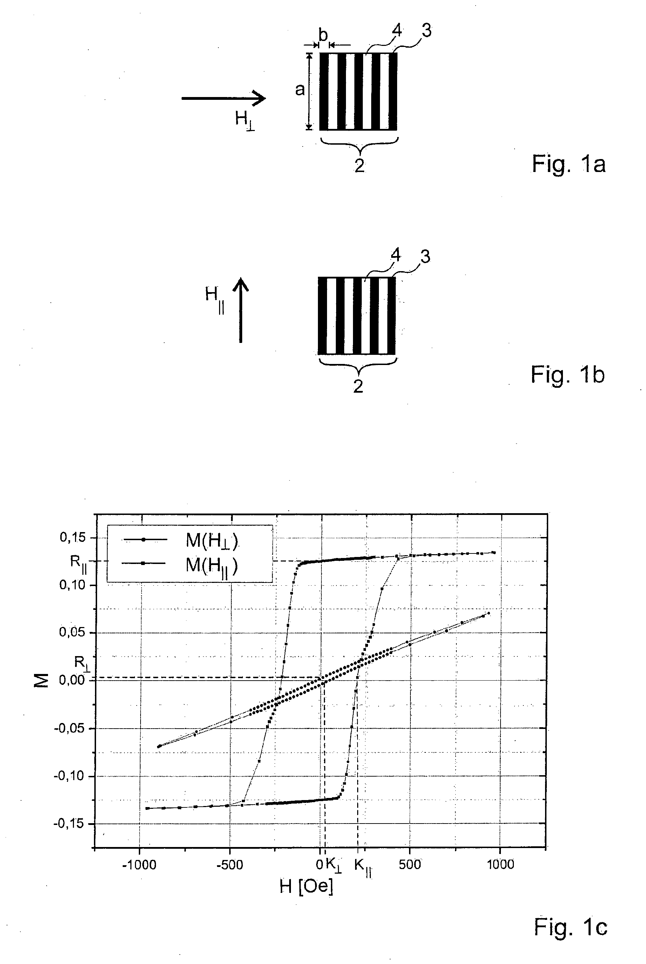

In Figur 1a ist ein Beispiel für einen gitterförmigen Magnetbereich 2 gezeigt. Dieser weist mehrere Gitterstreifen 3 aus magnetischem Material auf sowie dazwischen liegende nichtmagnetische Bereiche 4. Die Gitterstreifen 3 haben eine Länge a, die vorzugsweise mindestens dreimal größer ist als deren Breite b. Die Breite b der Gitterstreifen liegt z.B. im µm-Bereich oder darunter. Die Gitterstreifen weisen eine magnetische Formanisotropie auf, die dazu führt, dass die Gitterstreifen 3 in Abhängigkeit der Magnetfeldrichtung unterschiedlich magnetisierbar sind.

Durch ein Magnetfeld H_{∥}, das parallel zur Richtung der Gitterstreifen 3 verläuft, vgl. Fig. 1b, wird eine Magnetisierung der gitterförmigen Magnetbereiche 2 erreicht. Als Funktion der Stärke eines Magnetfelds H_{∥}, das in der Richtung parallel zu den Gitterstreifen angelegt wird, weist der gitterförmige Magnetbereich 2 eine Magnetisierungscharakteristik M(H_{∥}) mit geöffneter Hystereseform auf, die eine Koerzitivfeldstärke K_{∥} von etwa 200 Oe aufweist, vgl. Fig. 1c. Auch nach Entfernung des gitterförmigen Magnetbereichs 2 aus dem Magnetfeld H_{∥} verbleibt dabei eine große remanente Magnetisierung R_{∥}.

Durch ein Magnetfeld H⊥, das senkrecht zur Richtung der Gitterstreifen 3 verläuft, vgl. Fig. 1a, werden die gitterförmigen Magnetbereiche 2 dagegen deutlich schwächer magnetisiert. Als Funktion der Stärke eines Magnetfelds H⊥, das in der Richtung senkrecht zu den Gitterstreifen angelegt wird, weist der gitterförmige Magnetbereich 2 eine flache und nahezu geschlossene, im Wesentlichen linear verlaufende Magnetisierungscharakteristik M(H⊥) mit vernachlässigbar geringer Koerzitivfeldstärke (K⊥) auf, vgl. Fig. 1c. Nach Entfernung des gitterförmigen Magnetbereichs 2 aus dem Magnetfeld H⊥ verbleibt in diesem Fall nur eine vernachlässigbar geringe remanente Magnetisierung R⊥. Diese ist vorzugsweise mindestens einen Faktor 5 geringer als die remanente Magnetisierung R_{∥}.

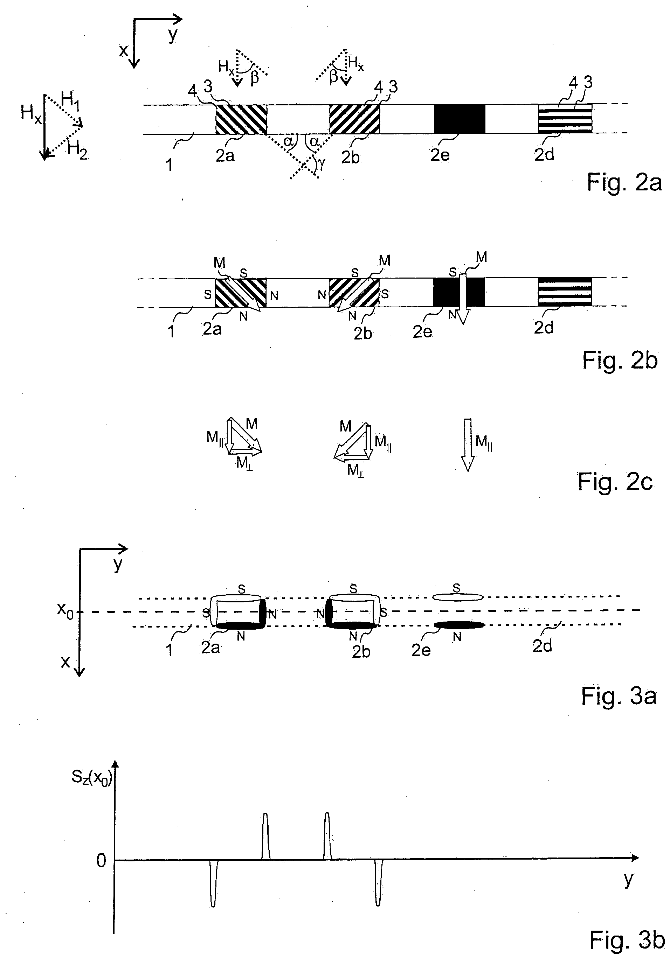

In Figur 2a ist eine Aufsicht auf ein Sicherheitselement 1 gezeigt. Entlang der Längsrichtung y des Sicherheitselements weist das Sicherheitselement 1 eine Magnetkodierung auf, die vier verschiedene Sorten von magnetischen Kodierungselementen 2a, 2b, 2d, 2e umfasst. Zwischen den Kodierungselementen 2a-d befindet sich kein magnetisches Material. Die Kodierungselemente 2a, 2b und 2d weisen jeweils einen gitterförmigen Magnetbereich auf, wobei die Richtung der Gitterstreifen 3 bei diesen Kodierungselementen jedoch unterschiedlich ist. Das magnetische Kodierungselement 2e weist einen konventionellen Magnetbereich auf, der keine Gitterstreifen aufweist, sondern in dem das magnetische Material durchgehend flächig aufgebracht ist. Die Gitterstreifen 3 der Kodierungselemente 2a und 2b verlaufen jeweils in einem spitzen Winkel α zur Längsrichtung y des Sicherheitselements 1. Entlang der Längsrichtung y betrachtet verlaufen die Gitterstreifen 3 des Kodierungselements 2a nach rechts und die Gitterstreifen 3 des Kodierungselements 2b nach links. Im gezeigten Beispiel verlaufen die Gitterstreifen des Kodierungselements 2b etwa senkrecht (γ≈90°) zu denen des Kodierungselements 2a und die beiden spitzen Winkel α betragen etwa 45°. Die Gitterstreifen 3 des Kodierungselements 2d verlaufen dagegen parallel zur Längsrichtung y des Sicherheitselements 1.

Das Sicherheitselement 1 wird z.B. durch ein Magnetfeld Hₓ magnetisiert, das entlang der x-Richtung, also senkrecht zur Längsrichtung y des Sicherheitselements 1 angelegt wird. Bei dem konventionellen Kodierungselement 2e führt das Magnetfeld Hₓ zu einer Magnetisierung M entlang der x-Richtung, also parallel zum Magnetfeld Hₓ. Nach Entfernen des Sicherheitselements 1 aus dem Magnetfeld Hₓ verbleibt bei dem Kodierungselement 2e eine remanente Magnetisierung parallel zu dem zuvor angelegten Magnetfeld Hₓ, die in Fig. 2b durch einen Pfeil auf dem Kodierungselement 2e eingezeichnet ist. Entsprechend der remanenten Magnetisierung weist das magnetisierte Kodierungselement 2e an einem Rand (oben in Fig. 2b) einen magnetischen Südpol auf (mit "S" gekennzeichnet) und an dem gegenüberliegenden Rand (unten in Fig. 2b) einen magnetischen Nordpol (mit "N" gekennzeichnet). Im Gegensatz dazu ergibt sich bei den Kodierungselementen 2a, 2b und 2d, die einen gitterförmigen Magnetbereich aufweisen, ein völlig anderes Magnetisierungsverhalten.

Das Kodierungselement 2d, dessen Gitterstreifen senkrecht zu dem Magnetfeld Hₓ verlaufen, wird durch das Magnetfeld Hₓ nicht oder nur vernachlässigbar gering in x-Richtung magnetisiert, entsprechend der Magnetisierungscharakteristik M(H⊥) aus Fig. 1c. Daher verbleibt bei diesem Kodierungselement 2d nur eine vernachlässigbar geringe remanente Magnetisierung (kein Pfeil in Fig. 2b und 2c). Zusätzlich kann das Sicherheitselement 1 auch weitere Kodierungselemente aufweisen, z.B. ein Kodierungselement mit einem gitterförmigen Magnetbereich, dessen Gitterstreifen parallel zur Magnetfeldrichtung x verlaufen. Bezüglich seiner Magnetisierung in x-Richtung verhält sich ein solches Kodierungselement qualitativ wie das konventionelle Kodierungselement 2e.

Das Magnetfeld Hₓ lässt sich vektoriell zerlegen in eine Magnetfeldkomponente H₁, die parallel zu den Gitterstreifen 3 des Kodierungselements 2a verläuft und in eine Magnetfeldkomponente H₂, die senkrecht zu den Gitterstreifen 3 des Kodierungselements 2a verläuft, vgl. Fig. 2a links. Aufgrund der magnetischen Formanisotropie der Gitterstreifen 3 wird das Kodierungselement 2a durch die in Richtung der Gitterstreifen gerichtete Magnetfeldkomponente H₁ magnetisiert während die senkrecht dazu gerichtete Magnetfeldkomponente H₂ die Magnetisierung M des Kodierungselements 2a kaum oder überhaupt nicht beeinflusst. Dagegen wird die Magnetisierung M des Kodierungselements 2b durch die Magnetfeldkomponente H₁ kaum oder überhaupt nicht beeinflusst, sondern das Kodierungselement 2b wird durch die Magnetfeldkomponente H₂ magnetisiert. Die Magnetisierung der Kodierungselemente (in Fig. 2b mit Pfeil eingezeichnet) verläuft sowohl bei dem Kodierungselement 2a als auch bei dem Kodierungselement 2b entlang der jeweiligen Gitterstreifen, also nicht parallel zu dem Magnetfeld Hₓ, sondern in einem spitzen Winkel zu Hₓ. Entsprechend der Magnetisierung weisen die Gitterstreifen 3 der Kodierungselemente 2a, 2b jeweils an einem ihrer Enden einen magnetischen Nordpol auf und an dem gegenüberliegenden Ende einen magnetischen Südpol. Im Gegensatz zu dem konventionellen Kodierungselement 2e sind nicht nur an dem oberen und unteren Rand der Kodierungselemente 2a, 2b, sondern auch an dem rechten und linken Rand der Kodierungselemente 2a, 2b ein magnetischer Nord- bzw. Südpol ausgebildet, vgl. Fig. 2b.

Die Magnetisierung M der Kodierungselemente 2a und 2b lässt sich vektoriell zerlegen in eine Magnetisierungskomponente M_{∥} parallel zum Magnetfeld Hₓ und in eine Magnetisierungskomponente M⊥ senkrecht zum Magnetfeld Hₓ, vgl. Fig. 2c. Die beiden Kodierungselemente 2a und 2b, deren Gitterstreifen 3 einen spitzen Winkel β zu dem Magnetfeld Hₓ bilden, weisen demzufolge nicht nur eine Magnetisierungskomponente in der Richtung parallel zu dem angelegten Magnetfeld (x-Richtung) auf, sondern auch eine Magnetisierungskomponente senkrecht zu dem angelegten Magnetfeld (y-Richtung). Im Gegensatz dazu weist die Magnetisierung M des konventionellen Kodierungselements 2e nur eine Magnetisierungskomponente parallel zu dem angelegten Magnetfeld auf (x-Richtung), aber keine Magnetisierungskomponente in der Richtung senkrecht zum angelegten Magnetfeld (y-Richtung), vgl. Fig. 2c rechts.

Nachdem das Sicherheitselement durch das Magnetfeld Hₓ magnetisiert wurde, werden Magnetsignale des Sicherheitselements durch einen Magnetsensor detektiert, um die magnetischen Eigenschaften des Sicherheitselements 1 zu prüfen. Je nach Art des Magnetsensors kann auch während der Detektion der Magnetsignale ein Magnetfeld auf das Sicherheitselement einwirken. Im folgenden Beispiel wird angenommen, dass während des Detektierens kein Magnetfeld auf das Sicherheitselement einwirkt.

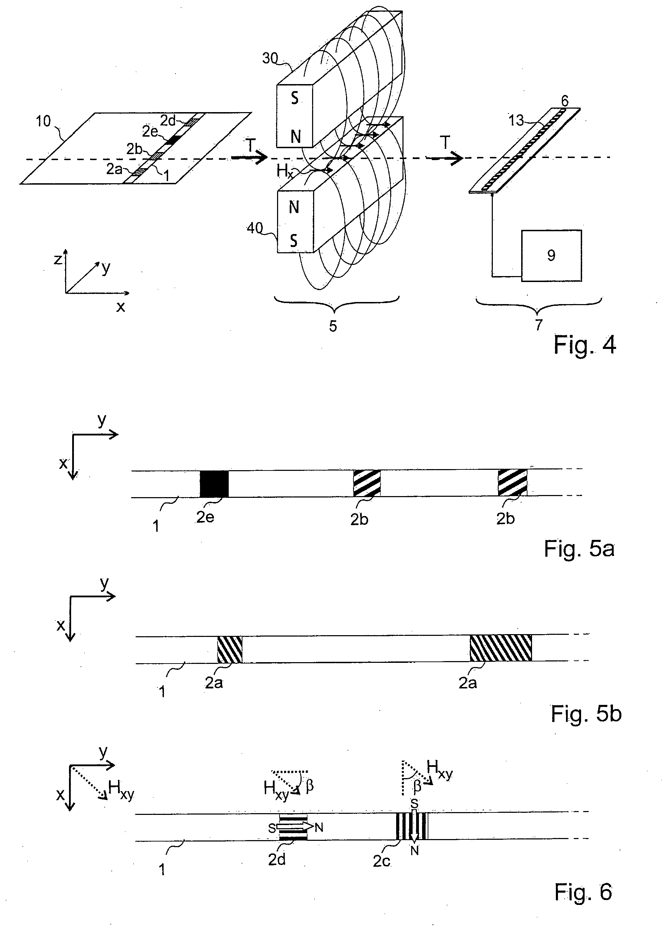

Figur 4 zeigt eine Anordnung zur Prüfung der magnetischen Eigenschaften des Sicherheitselements 1 bzw. des Wertdokuments 10. Die gezeigte Anordnung ist z.B. in einer Vorrichtung zur Wertdokumentbearbeitung enthalten, in die die Wertdokumente 10 einzeln oder stapelweise eingegeben werden, anschließend geprüft, sortiert und wieder ausgegeben oder in der Vorrichtung zur Wertdokumentbearbeitung abgespeichert werden. Ein Wertdokument 10 wird entlang eines Transportwegs T zuerst an einer Magnetisierungseinrichtung 5, zum Bereitstellen des Magnetfelds Hₓ vorbei transportiert und danach an einem Magnetsensor 7, der eine Sensorzeile 6 aufweist. Das Magnetfeld Hₓ wird z.B. durch zwei einander gegenüberliegende Magnete 30, 40 bereit gestellt, zwischen denen das Wertdokument 10 hindurch transportiert wird. Die Pole N, S der Magnete 30, 40 sind so ausgerichtet, dass sich zwischen diesen ein Magnetfeld Hₓ parallel zur Transportrichtung T ergibt (x-Richtung). Es sind jedoch auch andere Orientierungen der Magnetpole möglich. Alternativ kann die erste Magnetisierungseinrichtung 5 auch nur einseitig zum Transportweg S angeordnet sein, solange dadurch eine ausreichend große Magnetfeldstärke zum Magnetisieren des Magnetmaterials erzielt wird. Zum Beispiel kann das Magnetfeld Hₓ auch durch nur einen Magneten bereitgestellt werden.

Nach der Magnetisierung durch das Magnetfeld Hₓ wird das Wertdokument 10 an dem Magnetsensor 7 vorbeitransportiert, der räumlich getrennt von der Magnetisierungseinrichtung 5 in der Vorrichtung zur Wertdokumentbearbeitung eingebaut ist. Dazwischen können z.B. Verzweigungen oder Umlenkungen des Transportwegs vorgesehen sein. Der Magnetsensor 7 enthält eine Sensorzeile 6, die eine Vielzahl gleichartiger magnetosensitiver Elemente 13 aufweist, die in einer Zeile angeordnet sind. Jedes dieser magnetosensitiven Elemente 13 liefert ein Magnetsignal als Funktion der Zeit bzw. als Funktion der x-Position auf dem vorbeitransportierten Wertdokument 10. Die Sensorzeile 6 ist in direkter Nähe zur Transportebene des Wertdokuments 10 angeordnet. Es kann vorgesehen sein, dass die vorbeitransportierten Wertdokumente 10 die Oberfläche der Sensorzeile berühren, es kann aber auch ein geringer Abstand zwischen der Oberfläche der Sensorzeile 6 und dem vorbeitransportierten Wertdokument 10 vorgesehen sein. Die magnetosensitiven Elemente 13 sind z.B. jeweils auf einer gemeinsamen Leiterplatte angeordnet (Details nicht gezeigt), und mit einer Auswerteeinrichtung 9 verbunden, die die Magnetsignale der Elemente 13 auswertet.

Das Wertdokument 10 aus Fig. 4 weist ein Sicherheitselement 1 auf, das in diesem Beispiel als Sicherheitsfaden ausgebildet ist. Die Erfindung bezieht sich aber auch auf andere Arten magnetischer Sicherheitselemente von Wertdokumenten, z.B. auf Folienelemente, die auf das Wertdokument aufgebracht werden und die eine magnetische Kodierung aufweisen. Als Beispiel wird angenommen, dass das Sicherheitselement 1 die in Figur 2a gezeigte Magnetkodierung aufweist. Das Magnetfeld Hₓ ist parallel zur Transportrichtung x des Wertdokuments 10 orientiert und weist eine ausreichende Magnetfeldstärke auf, um die Gitterstreifen 3 der Kodierungselemente 2a, 2b des Sicherheitselements 1 zu magnetisieren. Durch das Magnetfeld Hₓ werden die Kodierungselemente 2a-c des Sicherheitselements 1 entsprechend der in Fig. 2b und 2c gezeigten Pfeile magnetisiert. Durch die Sensorzeile 6 werden Magnetsignale detektiert, die der remanenten Magnetisierung der Kodierungselemente 2a-c entsprechen. Durch das Vorbeitransportieren des Sicherheitselements 1 an der Sensorzeile 6 werden die Magnetsignale sowohl als Funktion der x- Richtung als auch als Funktion der y-Richtung detektiert. Das Wertdokument 10 bzw. das Sicherheitselement 1 wird dabei zweidimensional magnetisch abgescannt. Die magnetosensitiven Elemente 13 können zur Detektion von Magnetfeldern entlang der x- oder y- oder z-Richtung ausgebildet sein (verschiedene Empfindlichkeitsrichtungen möglich).

Im vorliegenden Beispiel sind die magnetosensitiven Elemente 13 zum Detektieren der Magnetfeldkomponente ausgebildet, die die Kodierungselemente 2 des Sicherheitselements 1 in z-Richtung hervorrufen. In Figur 3a ist das Magnetsignal S_{z} dargestellt, das die Sensorzeile 6 beim magnetischen Abscannen des Sicherheitselements 1 aus Fig. 2a als Funktion der x und y-Koordinate detektiert. Positive Werte des Magnetsignals S_{z} sind dabei schwarz eingezeichnet, negative Werte des Magnetsignals S_{z} sind weiß umrandet eingezeichnet. Zur Veranschaulichung sind in Fig. 3a auch die Ränder des Sicherheitselements 1 gestrichelt eingezeichnet. Der obere und der linke Rand des Kodierungselements 2a liefern ein negatives Magnetsignal S_{z}, entsprechend dem an diesen beiden Rändern vorliegenden magnetischen Südpol, vgl. Fig. 2b. Der untere und der rechte Rand des Kodierungselements 2a liefern ein positives Magnetsignal S_{z}, entsprechend dem an diesen Rändern vorliegenden magnetischen Nordpol, vgl. Fig. 2b. Umgekehrt liefern der obere und der rechte Rand des Kodierungselements 2b ein negatives Magnetsignal S_{z}, entsprechend dem an diesen beiden Rändern vorliegenden magnetischen Südpol, vgl. Fig. 2b. Der untere und der linke Rand des Kodierungselements 2b liefern ein positives Magnetsignal S_{z}, entsprechend dem an diesen Rändern vorliegenden magnetischen Nordpol, vgl. Fig. 2b. Das konventionelle Kodierungselement 2e liefert dagegen nur an seinem oberen Rand ein negatives Magnetsignal Sₛ (magnetischer Südpol) und an seinem unteren Rand ein positives Magnetsignal S_{z} (magnetischer Nordpol). Von dem Kodierungselement 2d wird - mangels remanenter Magnetisierung bei Magnetisierung entlang der x-Richtung - kein oder nur ein vernachlässigbar geringes Magnetsignal S_{z} detektiert.

In Fig. 3b ist der Verlauf des in z-Richtung detektierten Magnetsignals S_{z} als Funktion der Position entlang der Längsrichtung des Sicherheitselements 1 skizziert (y-Richtung), das dem Signal aus Fig. 3a an der Position x=x0 entspricht. Die Position x0 ist hier - entlang der Magnetfeldrichtung x betrachtet - etwa in der Mitte des Sicherheitselements 1 gewählt, da dort die Unterschiede des Magnetsignals der Kodierungselemente 2a-c besonders deutlich sind. Das Magnetsignal S_{z} des Sicherheitselements weist am linken Rand des Kodierungselements 2a und am rechten Rand des Kodierungselements 2b einen negativen Peak auf. Am rechten Rand des Kodierungselements 2a und am linken Rand des Kodierungselements 2b weist es einen positiven Peak auf. An den y-Koordinaten des konventionellen Kodierungselements 2e wird an der Position x=x0 überhaupt kein Magnetsignal S_{z} detektiert, genauso wie im Bereich des Kodierungselements 2d. Die beiden Kodierungselemente 2a und 2b weisen daher Magnetsignale S_{z} auf, die völlig anders sind als die des konventionellen Kodierungselements 2e. Auch durch konventionelle Magnetbereiche anderer Form und Größe können solche Magnetsignale, die die gitterförmigen Magnetbereiche der Kodierungselemente 2a, 2b liefern, nicht erzeugt werden. Die Kodierungselemente 2a und 2b mit gitterförmigem Magnetbereich erhöhen daher die Fälschungssicherheit eines Sicherheitselements, das eines oder mehrerer dieser Kodierungselemente aufweist.

Desweitern sind die beiden Kodierungselemente 2a und 2b anhand ihrer unterschiedlichen Magnetsignale, vgl. Fig. 3b, eindeutig voneinander unterscheidbar. Solche gitterförmigen Magnetbereiche mit unterschiedlicher Gitterrichtung können daher vorteilhaft für eine magnetische Kodierung des Sicherheitselements 1 aus unterschiedliche Kodierungselementen verwendet werden. Damit sind neue Basiselemente für eine magnetische Kodierung verfügbar, die eine fälschungssichere Alternative zu den Basiselementen der bisherigen Magnetkodierungen darstellen, die aus konventionellen hoch- und niederkoerzitiven Kodierungselementen bestehen.

Um die verschiedenen Magnetsignale der unterschiedlichen Kodierungselemente voneinander zu unterscheiden, können auch magnetosensitive Elemente 13 mit anderen Empfindlichkeitsrichtungen verwendet werden. Die Magnetsignale können auch durch magnetosensitive Elemente voneinander unterschieden werden, deren Empfindlichkeitsrichtung in der Ebene des Sicherheitselements (x-y-Ebene) liegt, z.B. kann die Empfindlichkeitsrichtung auch parallel, schräg oder senkrecht zur Längsrichtung y des Sicherheitselements 1 sein. Statt eines Magnetfelds Hₓ können zur Magnetisierung auch andere Magnetfeldrichtungen verwendet werden. Bevorzugt bildet das Magnetfeld mit der Richtung der Gitterstreifen jedoch einen spitzen Winkel.

In Fig. 5a ist ein Ausführungsbeispiel eines Sicherheitselements 1 gezeigt, das ein konventionelles Kodierungselement 2e aufweist und zwei Kodierungselemente 2b aufweist. Der Winkel, den die Gitterstreifen 3 der Kodierungselemente 2b mit der Längsrichtung y des Sicherheitselements 1 bilden, ist ein spitzer Winkel von etwa α=30°.

In Fig. 5b ist ein weiteres Ausführungsbeispiel eines Sicherheitselements 1 gezeigt, das zwei Kodierungselemente 2a aufweist. Der Winkel, den die Gitterstreifen 3 der Kodierungselemente 2a mit der Längsrichtung y des Sicherheitselements 1 bilden, ist ein spitzer Winkel von etwa α=60°.

Figur 6 zeigt ein Beispiel eines Sicherheitselements 1, das ein Kodierungselement 2d mit parallel zur Längsrichtung y des Sicherheitselements 1 verlaufenden Gitterstreifen 3 aufweist und ein Kodierungselement 2c mit senkrecht zur Längsrichtung y des Sicherheitselements 1 verlaufenden Gitterstreifen 3. Zur Magnetisierung wird in diesem Beispiel jedoch ein Magnetfeld H_{xy} angelegt, das schräg zu den Achsen x und y verläuft, z.B. in einem Winkel von 45°. Der Magnetfeldwinkel kann aber auch von 45° abweichen. Die Gitterstreifen schließen mit dem angelegten Magnetfeld H_{xy} wiederum einen spitzen Winkel β ein. Durch dieses Magnetfeld H_{xy} wird - aufgrund der anisotropen Magnetisierbarkeit der jeweiligen Gitterstreifen 3 - bei dem Kodierungselement 2d eine Magnetisierung parallel zur y-Richtung erzeugt und bei dem Kodierungselement 2c eine Magnetisierung parallel zur x-Richtung. Entsprechend entstehen der magnetische Nordpol N und der Südpol S bei den beiden Kodierungselement an unterschiedlichen Seiten dieser Kodierungselemente, vgl. Fig. 6. Ein konventionelles Kodierungselement 2ewürde dagegen an seiner rechten und an seiner unteren Seite jeweils einen magnetischen Nordpol und an seiner linken und seiner oberen Seite jeweils einen magnetischen Südpol erhalten. Entsprechend unterschieden sich auch die Magnetsignale, die die beiden Kodierungselementen 2d und 2c liefern, sowohl voneinander als auch von dem eines konventionellen Kodierungselements 2e.

## Patentansprüche

1. Sicherheitselement (1) zur Absicherung von Wertdokumenten, das eine magnetische Kodierung mit mindestens einem ersten magnetischen Kodierungselement (2, 2a-d) aufweist, wobei das erste magnetische Kodierungselement (2, 2a-d) einen gitterförmigen Magnetbereich aufweist, der durch mehrere parallel zueinander verlaufende Gitterstreifen (3, 33, 34, 83, 84) aus magnetischem Material gebildet ist, wobei die Gitterstreifen (3) des ersten magnetischen Kodierungselements (2, 2a-d) jeweils eine magnetische Anisotropie aufweisen, wobei die Breite (b) und Dicke (d) der Gitterstreifen (3, 33, 34, 83, 84) so gering gewählt sind, dass die Gitterstreifen (3, 33, 34, 83, 84) jeweils eine magnetische Formanisotropie aufweisen, deren magnetische Vorzugsrichtung entlang der Gitterstreifen verläuft, wobei die Breite der Gitterstreifen zwischen 100 nm und 5 µm liegt, wobei
- die magnetische Kodierung zwei oder mehrere erste Kodierungselemente (2, 2a-d) aufweist, die entlang einer Kodierungsrichtung (y) auf oder in dem Sicherheitselement angeordnet sind und die einen gitterförmigen Magnetbereich aufweisen, der durch mehrere parallel zueinander verlaufende Gitterstreifen (3, 33, 34, 83, 84) aus magnetischem Material gebildet wird, die jeweils eine magnetische Anisotropie aufweisen, wobei die Gitterstreifen jedes ersten Kodierungselements im Wesentlichen parallel zu den Gitterstreifen des/der anderen ersten Kodierungselements/e verlaufen, und wobei
- der Abstand zwischen jeweils zwei benachbarten Kodierungselementen mindestens 2 mm beträgt.

2. Sicherheitselement nach Anspruch 1, **dadurch gekennzeichnet, dass** die Gitterstreifen (3, 33, 34, 83, 84) der ersten Kodierungselemente in einem spitzen Winkel (α) zu der Kodierungsrichtung (y) des Sicherheitselements verlaufen, insbesondere in einem Winkel (α) zwischen 20° und 70°, bevorzugt zwischen 30° und 60°.

3. Sicherheitselement nach einem der vorhergehenden Ansprüche, **dadurch gekennzeichnet, dass** die magnetische Kodierung des Sicherheitselements (1) mindestens zwei erste magnetische Kodierungselemente (2a, 2c) und mindestens ein zweites magnetisches Kodierungselement (2b, 2d) aufweist, wobei die ersten magnetischen Kodierungselemente (2a, 2c) und das zweite magnetische Kodierungselement entlang der Kodierungsrichtung (y) auf oder in dem Sicherheitselement angeordnet sind, und wobei
- die ersten magnetischen Kodierungselemente (2a, 2c) jeweils einen gitterförmigen Magnetbereich aufweisen, der durch mehrere parallel zueinander verlaufende Gitterstreifen (3, 33, 34, 83, 84) aus magnetischem Material gebildet wird, die jeweils eine magnetische Anisotropie aufweisen, und
- das zweite magnetische Kodierungselement (2b, 2d) einen gitterförmigen Magnetbereich aufweist, der durch mehrere parallel zueinander verlaufende Gitterstreifen (3, 33, 34, 83, 84) aus magnetischem Material gebildet wird, die jeweils eine magnetische Anisotropie aufweisen, wobei die Gitterstreifen des zweiten magnetischen Kodierungselements (2b, 2d) in eine andere Richtung verlaufen als die Gitterstreifen der ersten magnetischen Kodierungselemente (2a, 2c).

4. Sicherheitselement nach Anspruch 3, **dadurch gekennzeichnet, dass** die Gitterstreifen (3, 33, 34, 83, 84) des zweiten magnetischen Kodierungselements (2b, 2d) in einem Winkel (γ) von 60° bis 120° zu den Gitterstreifen (3, 33, 34, 83, 84) der ersten magnetischen Kodierungselemente (2a, 2c) verlaufen, vorzugsweise in einem Winkel (γ) von 70° bis 110°.

5. Sicherheitselement nach einem der vorhergehenden Ansprüche, **dadurch gekennzeichnet, dass** die magnetische Anisotropie der Gitterstreifen (3, 33, 34, 83, 84) des jeweiligen magnetischen Kodierungselements, insbesondere des jeweiligen ersten und zweiten Kodierungselements, derart ausgebildet ist, dass das jeweilige magnetische Kodierungselement, insbesondere das jeweilige erste und zweite magnetische Kodierungselement,
- in der Magnetisierungsrichtung parallel zu den Gitterstreifen (3, 33, 34, 83, 84) eine Magnetisierungscharakteristik (M(H_{∥})) mit geöffneter Hystereseform aufweist, und
- in der Magnetisierungsrichtung senkrecht zu den Gitterstreifen (3, 33, 34, 83, 84) eine Magnetisierungscharakteristik (M(H⊥)) aufweist, die - im Vergleich zu der Magnetisierungscharakteristik (M(H_{∥})) in der Magnetisierungsrichtung parallel zu den Gitterstreifen - eine vernachlässigbar geringe remanente Magnetisierung (R⊥) aufweist.

6. Sicherheitselement nach einem der vorhergehenden Ansprüche, **dadurch gekennzeichnet, dass** die magnetische Anisotropie der Gitterstreifen (3, 33, 34, 83, 84) des jeweiligen magnetischen Kodierungselements, insbesondere des jeweiligen ersten und zweiten Kodierungselements, derart ausgebildet ist, dass
- die Magnetisierungscharakteristik (M(H⊥)) mit geöffneter Hystereseform, die das jeweilige magnetische Kodierungselement in der Magnetisierungsrichtung parallel zu den Gitterstreifen aufweist, eine Koerzitivfeldstärke (K_{∥}) von mindestens 10 Oe aufweist, vorzugsweise von mindestens 50 Oe, und
- die Magnetisierungscharakteristik (M(H_{∥})), die das jeweilige magnetische Kodierungselement in der Magnetisierungsrichtung senkrecht zu den Gitterstreifen aufweist, eine - im Vergleich zu der Magnetisierungscharakteristik in der Magnetisierungsrichtung parallel zu den Gitterstreifen - vernachlässigbar geringe Koerzitivfeldstärke (K⊥) aufweist.

7. Folienmaterial, welches das Sicherheitselement nach einem der vorhergehenden Ansprüche aufweist.

8. Wertdokument welches das Sicherheitselement nach einem der Ansprüche 1 bis 6 aufweist.

9. Verfahren zur Herstellung des Sicherheitselements nach einem der Ansprüche 1 bis 6, bei dem die Gitterstreifen (3, 33, 34, 83, 84) des jeweiligen Kodierungselements, insbesondere des jeweiligen ersten und zweiten Kodierungselements, jeweils aus einer magnetischen Beschichtung hergestellt werden, die mit Hilfe eines Beschichtungsverfahrens auf ein Substrat (20) des Sicherheitselements aufgebracht ist.

10. Verfahren nach Anspruch 9, **dadurch gekennzeichnet, dass**, zur Herstellung der Gitterstreifen, die magnetischen Beschichtung auf ein gitterförmiges Oberflächenrelief aufgebracht wird, welches zuvor in eine Schicht (82) des Sicherheitselements eingebracht, insbesondere eingeprägt wurde.

11. Verfahren nach Anspruch 9, **dadurch gekennzeichnet, dass** die Gitterstreifen durch ein Metalltransferverfahren hergestellt werden, bei dem
- in einer Schicht (23) eines ersten Substrats (20) ein gitterförmiges Oberflächenrelief hergestellt wird und dieses anschließend mit magnetischem Material beschichtet wird, so dass sich sowohl auf den erhabenen Stellen als auch auf den Vertiefungen des gitterförmigen Oberflächenreliefs magnetische Bereiche (33, 34) bilden,
- ein zweites Substrat (50), das mit einer Kleberschicht (53) versehen ist, mit dem ersten Substrat (20) in Verbindung gebracht wird, so dass die Kleberschicht (53) des zweiten Substrats mit den magnetischen Bereichen (33) des ersten Substrats in Kontakt kommt, die auf den erhabenen Stellen des gitterförmigen Oberflächenreliefs vorhanden sind,
- das erste und zweite Substrat (20, 50) anschließend wieder voneinander getrennt werden, wobei das magnetische Material (33) der erhabenen Stellen an der Kleberschicht (53) haften bleibt und sich von dem ersten Substrat (20), insbesondere von der Schicht (23) des ersten Substrats (20), ablöst.

12. Verfahren nach Anspruch 9, **dadurch gekennzeichnet, dass** die magnetische Beschichtung auf ein Substrat (20) des Sicherheitselements (1) flächig aufgebracht wird und die aufgebrachte magnetische Beschichtung in den Zwischenbereichen (4) der Gitterstreifen anschließend wieder entfernt wird, insbesondere durch Ätzen oder mittels eines Waschfarbeverfahrens oder mittels eines Photolack-Liftoff-Verfahrens oder durch Bestrahlung mit einem Laser.

13. Verfahren nach Anspruch 9, **dadurch gekennzeichnet, dass** auf ein Substrat des Sicherheitselements eine magnetische Beschichtung aufgebracht wird und dass die Gitterstreifen des jeweiligen Kodierungselements durch Prägen der magnetischen Beschichtung hergestellt werden.

14. Verfahren zur Prüfung eines Wertdokuments, das ein Sicherheitselement (1) nach einem der Ansprüche 1 bis 6 aufweist, mit Hilfe eines Magnetsensors (7), der Magnetsignale des Sicherheitselements (1) detektiert, **dadurch gekennzeichnet, dass** zum Magnetisieren der magnetischen Kodierungselemente (2, 2a-d), vor und/ oder während des Detektierens der Magnetsignale ein Magnetfeld (Hₓ, H_{xy}) auf das Sicherheitselement (1) einwirkt, dessen Richtung in einem spitzen Winkel (β) zu den Gitterstreifen (3, 33, 34, 83, 84) zumindest eines der magnetischen Kodierungselemente (2, 2a-d) verläuft.

## Claims

1. A security element (1) for safeguarding value documents which has a magnetic coding with at least one first magnetic coding element (2, 2a-d), wherein the first magnetic coding element (2, 2a-d) has a grid-shaped magnetic region which is formed by a plurality of mutually parallel grid strips (3, 33, 34, 83, 84) made of magnetic material, the grid strips (3) of the first magnetic coding element (2, 2a-d) respectively having a magnetic anisotropy, the width (b) and thickness (d) of the grid strips (3, 33, 34, 83, 84) being chosen so small that the grid strips (3, 33, 34, 83, 84) respectively have a magnetic shape anisotropy whose preferential magnetic direction extends along the grid strips, the width of the grid strips being between 100 nm and 5 µm, wherein
- the magnetic coding has two or a plurality of first coding elements (2, 2a-d) which are arranged along a coding direction (y) on or in the security element (1) and which have a grid-shaped magnetic region which is formed from a plurality of mutually parallel grid strips (3, 33, 34, 83, 84) made of magnetic material, which respectively have a magnetic anisotropy, the grid strips of each first coding element extend substantially parallel to the grid strips of the one or more other first coding element/s, and wherein
- the distance between respectively two neighboring coding elements is at least 2 mm.

2. The security element according to claim 1, **characterized in that** the grid strips (3, 33,34, 83, 84) of the first coding elements extend at an acute angle (α) to the coding direction (y) of the security element, in particular at an angle (α) between 20° and 70°, preferably between 30° and 60°.

3. The security element according to any of the preceding claims, **characterized in that** the magnetic coding of the security element (1) has at least two first magnetic coding elements (2a, 2c) and at least one second magnetic coding element (2b, 2d), the first magnetic coding elements (2a, 2c) and the second magnetic coding element being arranged along the coding direction (y) on or in the security element, and wherein
- the first magnetic coding elements (2a, 2c) respectively have one grid-shaped magnetic region which is formed by a plurality of mutually parallel grid strips (3, 33, 34, 83, 84) made of magnetic material which respectively have a magnetic anisotropy, and
- the second magnetic coding element (2b, 2d) have a grid-shaped magnetic region which is formed by a plurality of mutually parallel grid strips (3, 33, 34, 83, 84) made of magnetic material which respectively have a magnetic anisotropy, the grid strips of the second magnetic coding element (2b, 2d) extending in another direction than the grid strips of the first magnetic coding elements (2a, 2c).

4. The security element according to claim 3, **characterized in that** the grid strips (3, 33, 34, 83, 84) of the second magnetic coding element (2b, 2d) extend at an angle (γ) of 60° to 120° to the grid strips (3, 33, 34, 83, 84) of the first magnetic coding element (2a, 2c), preferably at an angle (γ) of 70° to 110°.

5. The security element according to any of the preceding claims, **characterized in that** the magnetic anisotropy of the grid strips (3, 33, 34, 83, 84) of the respective magnetic coding element, in particular of the respective first and second coding element, is configured such that the respective magnetic coding element, in particular the respective first and second magnetic coding element,
- has in the magnetization direction parallel to the grid strips (3, 33, 34, 83, 84) a magnetization characteristic (M(H_{∥})) with an open hysteretic shape, and
- has in the magnetization direction perpendicular to the grid strips (3, 33, 34, 83, 84) a magnetization characteristic (M(H⊥)) that has a negligibly small remanent magnetization (R⊥), in comparison to the magnetization characteristic (M(H_{∥})) in the magnetization direction parallel to the grid strips.

6. The security element according to any of the preceding claims, **characterized in that** the magnetic anisotropy of the grid strips (3, 33, 34, 83, 84) of the respective magnetic coding element, in particular of the respective first and second coding element, is configured such that
- the magnetization characteristic (M(H⊥)) with the open hysteretic shape that the respective magnetic coding element has in the magnetization direction parallel to the grid strips has a coercive field strength (K_{∥}) of at least 10 Oe, preferably at least 50 Oe, and
- the magnetization characteristic (M(H_{∥})) that the respective magnetic coding element has in the magnetization direction perpendicular to the grid strips has a negligibly small coercive field strength (K⊥), in comparison to the magnetization characteristic in the magnetization direction parallel to the grid strips.

7. A foil material having the security element according to any of the preceding claims.

8. A value document having the security element according to any of claims 1 to 6.

9. A method for manufacturing the security element according to any of claims 1 to 6, wherein the grid strips (3, 33, 34, 83, 84) of the respective coding element, in particular of the respective first and second coding element, are respectively manufactured from a magnetic coating which is applied to a substrate (20) of the security element using a coating method.

10. The method according to claim 9, **characterized in that**, for manufacturing the grid strips, the magnetic coating is applied to a grid-shaped surface relief which was previously incorporated into a layer (82) of the security element, in particular embossed thereinto.

11. The method according to claim 9, **characterized in that** the grid strips are manufactured by a metal transfer method, wherein
- in a layer (23) of a first substrate (20) a grid-shaped surface relief is manufactured and the latter is subsequently coated with magnetic material, so that magnetic regions (33, 34) form both on the raised places and on the depressions of the grid-shaped surface relief,
- a second substrate (50) which is provided with an adhesive layer (53) is connected to the first substrate (20), so that the adhesive layer (53) of the second substrate comes in contact with the magnetic regions (33) of the first substrate which are present on the raised places of the grid-shaped surface relief,
- the first and second substrates (20, 50) are subsequently mutually separated again, the magnetic material (33) of the raised places remaining adhering to the adhesive layer (53) and being detached from the first substrate (20), in particular from the layer (23) of the first substrate (20).

12. The method according to claim 9, **characterized in that** the magnetic coating is applied areally onto a substrate (20) of the security element (1), and the applied magnetic coating is subsequently removed again in the intermediate regions (4) of the grid strips, in particular by etching or by means of a washing-ink method or by means of a photoresist lift-off method or by irradiation with a laser.

13. The method according to claim 9, **characterized in that** a magnetic coating is applied onto a substrate of the security element, and that the grid strips of the respective coding element are manufactured by embossing the magnetic coating.

14. A method for checking a value document which has a security element (1) according to any of claims 1 to 6, using a magnetic sensor (7) which detects magnetic signals of the security element (1), **characterized in that**, for magnetizing the magnetic coding elements (2, 2a-d), there acts on the security element (1) before and/or during the detection of the magnetic signals a magnetic field (Hₓ, H_{xy}) whose direction extends at an acute angle (β) to the grid strips (3, 33, 34, 83, 84) of at least one of the magnetic coding elements (2, 2a-d).

## Revendications

1. Elément de sécurité (1) destiné à la sécurisation de documents de valeur, qui comporte une codification magnétique ayant au moins un premier élément magnétique de codification (2, 2a-d), cependant que le premier élément magnétique de codification (2, 2a-d) comporte une zone magnétique en forme de grille constituée par plusieurs rubans en grille (3, 33, 34, 83, 84) en matériau magnétique parallèles entre eux, cependant que les rubans en grille (3) du premier élément magnétique de codification (2, 2a-d) présentent respectivement une anisotropie magnétique, cependant que la largeur (b) et l'épaisseur (d) des rubans en grille (3, 33, 34, 83, 84) sont choisies si faibles que les rubans en grille (3, 33, 34, 83, 84) présentent respectivement une anisotropie magnétique de forme dont la direction magnétique préférentielle évolue le long des rubans en grille, cependant que la largeur des rubans en grille est comprise entre 100 nm et 5 µm,
cependant que
- la codification magnétique comporte deux ou plusieurs premiers éléments de codification (2, 2a-d) qui sont disposés le long d'une direction de codification (y) sur ou dans l'élément de sécurité et qui comportent une zone magnétique en forme de grille constituée par plusieurs rubans en grille (3, 33, 34, 83, 84) en matériau magnétique parallèles entre eux qui présentent respectivement une anisotropie magnétique, cependant que les rubans en grille de chaque premier élément de codification sont essentiellement parallèles aux rubans en grille du/des autre(s) premier(s) élément(s) de codification, et cependant que
- l'espacement entre respectivement deux éléments de codification adjacents est d'au moins 2 mm.

2. Elément de sécurité selon la revendication 1, **caractérisé en ce que** les rubans en grille (3, 33, 34, 83, 84) des premiers éléments de codification décrivent un angle aigu (α) avec la direction de codification (y) de l'élément de sécurité, en particulier un angle (α) compris entre 20° et 70°, de préférence entre 30° et 60°.

3. Elément de sécurité selon une des revendications précédentes, **caractérisé en ce que** la codification magnétique de l'élément de sécurité (1) comporte au moins deux premiers éléments magnétiques de codification (2a, 2c) et au moins un deuxième élément magnétique de codification (2b, 2d), cependant que les premiers éléments magnétiques de codification (2a, 2c) et le deuxième élément magnétique de codification sont disposés le long de la direction de codification (y) sur ou dans l'élément de sécurité, et cependant que
- les premiers éléments magnétiques de codification (2a, 2c) comportent respectivement une zone magnétique en forme de grille constituée par plusieurs rubans en grille (3, 33, 34, 83, 84) en matériau magnétique parallèles entre eux, lesquels présentent respectivement une anisotropie magnétique, et
- le deuxième élément magnétique de codification (2b, 2d) comporte une zone magnétique en forme de grille constituée par plusieurs rubans en grille (3, 33, 34, 83, 84) en matériau magnétique parallèles entre eux, lesquels présentent respectivement une anisotropie magnétique, cependant que les rubans en grille du deuxième élément magnétique de codification (2b, 2d) s'étendent dans une autre direction que les rubans en grille des premiers éléments magnétiques de codification (2a, 2c).

4. Elément de sécurité selon la revendication 3, **caractérisé en ce que** les rubans en grille (3, 33, 34, 83, 84) du deuxième élément magnétique de codification (2b, 2d) décrivent un angle (□) compris entre 60° et 120° avec les rubans en grille (3, 33, 34, 83, 84) des premiers éléments magnétiques de codification (2a, 2c), de préférence un angle (□) compris entre 70° et 110°.

5. Elément de sécurité selon une des revendications précédentes, **caractérisé en ce que** l'anisotropie magnétique des rubans en grille de l'élément magnétique de codification respectif, en particulier celle du premier et du deuxième élément de codification respectif, est réalisée de telle façon que l'élément magnétique de codification respectif, en particulier le premier et le deuxième élément magnétique de codification respectif,
- présente dans la direction de magnétisation parallèle aux rubans en grille (3, 33, 34, 83, 84) une caractéristique de magnétisation (M(H_{∥})) à forme d'hystérésis ouverte, et
- présente dans la direction de magnétisation perpendiculaire aux rubans en grille (3, 33, 34, 83, 84) une caractéristique de magnétisation (M(H⊥)) qui, en comparaison avec la caractéristique de magnétisation (M(H_{∥})) dans la direction de magnétisation parallèle aux rubans en grille, présente une magnétisation (R⊥) rémanente insignifiante.

6. Elément de sécurité selon une des revendications précédentes, **caractérisé en ce que** l'anisotropie magnétique des rubans en grille (3, 33, 34, 83, 84) de l'élément magnétique de codification respectif, en particulier celle du premier et du deuxième élément de codification respectif, est réalisée de telle façon que
- la caractéristique de magnétisation (M(H⊥)) à forme d'hystérésis ouverte que présente l'élément magnétique de codification respectif dans la direction de magnétisation parallèle aux rubans en grille présente une intensité de champ coercitif (K_{∥}) d'au moins 10 Oe, de préférence d'au moins 50 Oe, et
- la caractéristique de magnétisation (M(H_{∥})) que présente l'élément magnétique de codification respectif dans la direction de magnétisation perpendiculaire aux rubans en grille présente, en comparaison avec la caractéristique de magnétisation dans la direction de magnétisation parallèle aux rubans en grille, une intensité de champ coercitif (K⊥) insignifiante.

7. Matériau en film que comporte l'élément de sécurité selon une des revendications précédentes.

8. Document de valeur qui comporte l'élément de sécurité selon une des revendications de 1 à 6.

9. Procédé de fabrication d'un élément de sécurité selon une des revendications de 1 à 6, dans lequel les rubans en grille (3, 33, 34, 83, 84) de l'élément de codification respectif, en particulier ceux du premier et du deuxième élément de codification respectif, sont respectivement fabriqués à partir d'un revêtement magnétique appliqué à l'aide d'un procédé de revêtement sur un substrat (20) de l'élément de sécurité.

10. Procédé selon la revendication 9, **caractérisé en ce que**, pour la fabrication des rubans en grille, le revêtement magnétique est appliqué sur un relief de surface en forme de grille qui a été auparavant généré dans une couche (82) de l'élément de sécurité, en particulier gaufré.

11. Procédé selon la revendication 9, **caractérisé en ce que** les rubans en grille sont fabriqués par un procédé de transfert de métal dans lequel
- dans une couche (23) d'un premier substrat (20), un relief de surface en forme de grille est créé, et que ce dernier est ensuite revêtu de matériau magnétique, de telle sorte que, tant sur les endroits surélevés que sur les renfoncements du relief de surface en forme de grille, des zones magnétiques (33, 34) se forment,
- un deuxième substrat (50), pourvu d'une couche de colle (53), est mis en jonction avec le premier substrat (20), de telle sorte que la couche de colle (53) du deuxième substrat vient en contact avec les zones magnétiques (33) du premier substrat qui se trouvent sur les endroits surélevés du relief de surface en forme de grille,
- le premier et le deuxième substrat (20, 50) sont ensuite à nouveau séparés l'un de l'autre, cependant que le matériau magnétique (33) des endroits surélevés reste collé à la couche de colle (53) et se détache du premier substrat (20), en particulier de la couche (23) du premier substrat (20).

12. Procédé selon la revendication 9, **caractérisé en ce que** le revêtement magnétique est appliqué en surface sur un substrat (20) de l'élément de sécurité (1), et que le revêtement magnétique appliqué est ensuite à nouveau enlevé dans les zones intermédiaires (4) des rubans en grille, en particulier par décapage ou au moyen d'un procédé à encre lavable ou au moyen d"un procédé de lift-off/photoréserve ou par irradiation au laser.

13. Procédé selon la revendication 9, **caractérisé en ce que**, sur un substrat de l'élément de sécurité, un revêtement magnétique est appliqué, et que les rubans en grille de l'élément de codification respectif sont créés par gaufrage du revêtement magnétique.

14. Procédé de fabrication d'un document de valeur qui comporte un élément de sécurité (1) selon une des revendications de 1 à 6, à l'aide d'un capteur magnétique (7) qui détecte des signaux magnétiques de l'élément de sécurité (1), **caractérisé en ce que**, pour la magnétisation des éléments magnétiques de codification (2, 2a-d), avant et/ou pendant la détection des signaux magnétiques, un champ magnétique (Hₓ, H_{xy}) agit sur l'élément de sécurité (1), dont la direction décrit un angle aigu (β) avec les rubans en grille (3, 33, 34, 83, 84) d'au moins un des éléments magnétiques de codification (2, 2a-d).
